# EUROPEAN PATENT SPECIFICATION

(11) **EP 0 306 287 B1**
(45) Date of publication and mention of the grant of the patent: **06.12.1995**
(21) Application number: 88308048.3
(22) Date of filing: 31.08.1988
(51) Int. Cl.: H01L 39/24, H01F 6/06

(54) **Superconducting ceramic circuits and manufacturing method for the same**
Supraleitende Schaltungen aus Keramik und Verfahren zu ihrer Herstellung
Circuits supraconducteurs en céramique et méthode pour leur fabrication

(30) Priority: 31.08.1987 JP 218538/87; 31.08.1987 JP 218539/87; 06.09.1987 JP 222622/87; 06.09.1987 JP 222623/87
(43) Date of publication of application: 08.03.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo (JP)
(74) Representative: Milhench, Howard Leslie

(56) References cited:
- EP-A- 0 274 407
- EP-A- 0 292 125
- EP-A- 0 298 461

## Description

This invention relates to superconducting ceramic circuits and methods of manufacturing the same.

It has been known to use metallic materials such as Nb₃Ge to wind a coil to form a superconducting magnet having a high Tc since a metallic material has a high ductility and a high malleability. In recent years, superconducting ceramics which have a high Tc have been attracting the interest of researchers.

However, such superconducting ceramics are fragile because of low ductility and malleability so that it is virtually impossible to form a superconducting coil with a wire made of such superconducting ceramics.

EP-A-292,125 was cited under Art. 54(3) and (4) EPC by the European Patent Office during examination. The citation describes a multilayer superconductive circuit comprising ceramic insulating layers and patterned ceramic oxide superconductive layers, the insulating layers having through holes for interconnecting the superconductive layers together.

### SUMMARY OF THE INVENTION

Therefore the present invention aims to provide a high Tc superconductor in the form of wires or strips with high reliability and to provide a method of manufacturing high Tc superconductors in the form of wires for strips which method is suitable for mass-production with a high yield.

In accordance with a first aspect of the invention, there is provided a multilayered superconductive circuit comprising:
a lower superconductive coil made of a superconductive ceramic material;
an intervening insulating ceramic layer formed on said lower superconductive coil; and
an upper superconductive coil made of a superconductive ceramic material insulated from said lower superconductive coil by said insulating ceramic layer.

In accordance with a second aspect of the invention, there is provided a method of manufacturing a multilayered superconductive circuit comprising:
forming a first superconductive coil made of a superconductive ceramic material;
insulating said first coil by covering the coil with an insulating layer made of a ceramic material; and
forming a second superconductive coil made of a superconductive ceramic material.

In accordance with an embodiment of the present invention, an oxide mixture for constituting a superconducting ceramic is deposited in the form of a thin film on a substrate. This deposition can be performed by various methods including sputtering such as magnetron sputtering, printing such as screen press printing, spraying such as plasma spraying, or electron beam evaporation. The deposited ceramic film is then fired at 500-1000°C, e.g. 900°C for 15 hours. After gradually cooling at a rate of 200°C/min or slower, e.g. 10°C/min, the ceramic film is further oxidized at 450°C for an hour, if necessary. During the deposition, firing and oxidizing, a magnetic field may be applied to the deposited film in order to expedite the formation of crystalline structure.

The superconducting film is irradiated and scanned with a laser beam which is directed along a prescribed pattern in order to partly remove the film. Examples of lasers for this use are YAG lasers (1.06 microns), excimer lasers (KrF or KrCl), Argon lasers, and Nitrogen lasers. YAG lasers can emit infrared light pulses (having a circular cross section) at a frequency of 5-100KHz. The pulse width of YAG lasers is not shorter than 50 nm, and therefore, if fine control of processing depths of laser scribing is desired, excimer lasers are suitable for this application because their pulse width can be as short as 20 microns. By focusing with an optical system, it is possible to reduce the diameter of excimer laser beams to 10-100 microns. A representative pattern that is used is a spiral which forms a superconducting coil. The superconducting pattern on the substrate is covered with an insulating coating. It is important to make the insulating coating from a material whose thermal expansion coefficient is approximately equal to that of the superconducting pattern. The insulating coating is non-superconducting and preferably made of a ceramic material similar to that of the superconducting pattern. A portion of the insulating coating just above the end of the super-conducting coil is removed to provide an opening. Then, another superconducting ceramic film is superimposed on the insulating film and patterned into an upper spiral form in order to be coupled with the lower superconducting coil through the opening. The windings of the upper and lower spirals have to be in opposite directions so that their inductances are summed rather than cancelled out.

Preferred examples of the insulating films used in contact with the superconducting pattern are represented by the stoichiometric formula, referred to "non-superconducting ceramics" hereinafter, [(A′ₚA˝₁₋ₚ)₁₋ₓ(B′_{q}B˝_{1-q})ₓ]_{y}(CUᵣX₁₋ᵣ)_{z}O_{w}, where A′ is one or more elements of Group IIIa of the Periodic Table, e.g., the rare earth elements or lanthanides, B′ is one or more alkaline earth metals, i.e. Ba, Sr and Ca, A˝, B˝ and X are selected from a group consisting of Mg, Be, Al, Fe, Co, Ni, Cr, Ti, Mn and Zr, and 0.1≦x≦1; y = 2.0 - 4.0, preferably 2.5 - 3.5; z = 1.0 - 4.0, preferably 1.5 - 3.5; and w = 4.0 - 10.0, preferably 6.0 - 8.0. The numbers p, q and r are chosen to be 0.99 to 0.80 so that the total proportion of A˝, B˝ and X is 1-20 vol% in the ceramic material, particularly in case of Mg and Al, the proportion may be 1-5%.

Preferred examples of the superconducting ceramic materials used in accordance with the present invention for forming coils or other patterns are represented by the stoichiometric formula, (A₁₋ₓBₓ)_{y}Cu_{z}O_{w}, where A is one or more elements of Group IIIa of the Periodic Table, e.g., the rare earth elements or lanthanides, B is one or more alkaline earth metals, i.e. Ba, Sr and Ca, and 0<x<1; y = 2.0 - 4.0, preferably 2.5 - 3.5; z = 1.0 - 4.0, preferably 1.5 - 3.5; and w = 4.0 - 10.0, preferably 6.0 - 8.0.

The non-superconducting ceramic film and the superconducting ceramic film can be formed by a spraying method for example. Namely, nitrates, hydrochlorides, and/or oxalates of the elements are dissolved in water and neutralized by ammonia in order to produce extremely fine particles. These fine particles are coated on a surface, dried and fired in an oxidizing atmosphere such as an excited oxygen atmosphere. This firing process can be carried out at relatively low temperatures by making use of an O₃ atmosphere.

### BRIEF DESCRIPTION OF THE DRAWINGS

Fig.1(A) is a perspective view showing the manufacturing process of a superconducting coil embodying the present invention.

Fig.1(B) is a cross sectional view through A-A′ showing the superconducting coil in Fig.1(A).

Fig.2(A) is a perspective view showing the manufacturing process of another superconducting coil in accordance with another embodiment of the present invention.

Fig.2 (B) is a cross sectional view through A-A′ showing the superconducting coil in Fig. 2(A).

### DETAILED DESCRIPTION OF THE EMBODIMENTS

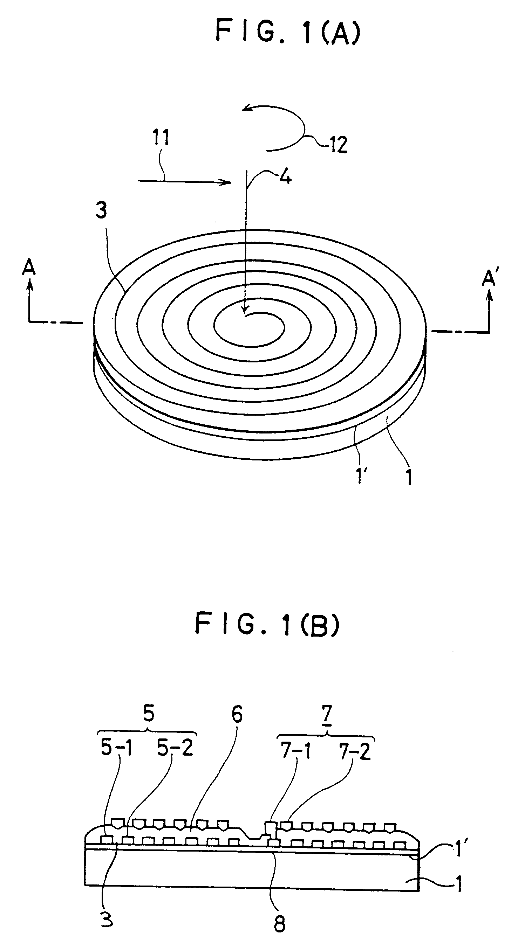

Referring to Figs.1(A) and (B), a superconducting coil in accordance with the present invention is illustrated. A circular substrate 1 is made of a ceramic material such as Alumina, Silicon Oxide, Aluminium Nitride, Zirconia, Yttria or YSZ(Yttria stabilized Zircon), or a metal or a quartz glass. YSZ, Yttria or Zirconia are particularly suitable having regard to the desirability of matching the coefficient of thermal expansion rate of the substrate 1 to that of a superconducting film formed thereon as hereinafter described. The differential coefficient of thermal expansion between the underlying substrate 1 and the overlying ceramic thin film to cover them should be as small as possible preferably within 50% of the coefficient of thermal expansion of the ceramic thin film. If the substrate 1 and the ceramic thin film have substantially different thermal coefficients, the strain caused between them may hinder the formation of a superconducting structure because of the recrystallization of the ceramic films. The surface of the substrate may be coated with a "non-superconducting ceramic" material prior to formation of the superconducting film.

Prescribed amounts of oxides, carbonates and/or halides are mixed together in a ball mill, compacted and fired. The fired mixture is deposited on the substrate 1 at a substrate temperature of 650°C to a thickness of 0.1 to 50 microns, e.g. 20 microns by magnetron sputtering using a target composed of the fired mixture and in an oxygen atmosphere containing 20% Argon. The deposited film is annealed at 850°C for 8 hours, gradually cooled at 4°C per minute and annealed again at 400°C for 2 hours. As a result, a superconducting structure of the ceramic material which is sublimable is formed with its (a,b) plane in parallel to the plane of the substrate.

Next, the surface of the superconducting film is scanned and irradiated with laser pulses from an excimer laser (254nm) of 50 microns diameter along a spiral path 3 while the circular substrate is being rotated. The laser pulse location 4 is shifted from a peripheral position toward the center of the circular substrate 1 along the spiral path 3. By virtue of the laser pulses, the irradiated portion of the superconducting film is removed by sublimation, and a spiral groove 3 is formed which defines a resultant superconducting spiral pattern 5. The peak output power level of the laser pulses is 10⁶ to 10⁸ W/sec. Alternatively, this laser scribing may be performed before the annealing of the ceramic film.

The superconducting spiral 5 on the upper surface 1′ of the substrate 1 is isolated by coating an insulating film 6 made of a "non-superconducting ceramic". It is important that the insulating film 6 is selected to have a thermal expansion coefficient approximately equal to that of the superconducting spiral 5. A portion of the insulating film 6 is removed to form an opening in order to expose the inner end 8 of the superconducting spiral 5. A ceramic oxide film is deposited again on the structure, fired and patterned in the same manner to form an upper superconducting ceramic spiral 7. The upper superconducting ceramic spiral 7 is formed to turn in a reverse direction to the lower superconducting ceramic spiral 5. Since the upper and lower spirals 7 and 5 are coupled through the opening at the inner ends 8 of the spirals, a double-layered coil is constructed with a doubled inductance.

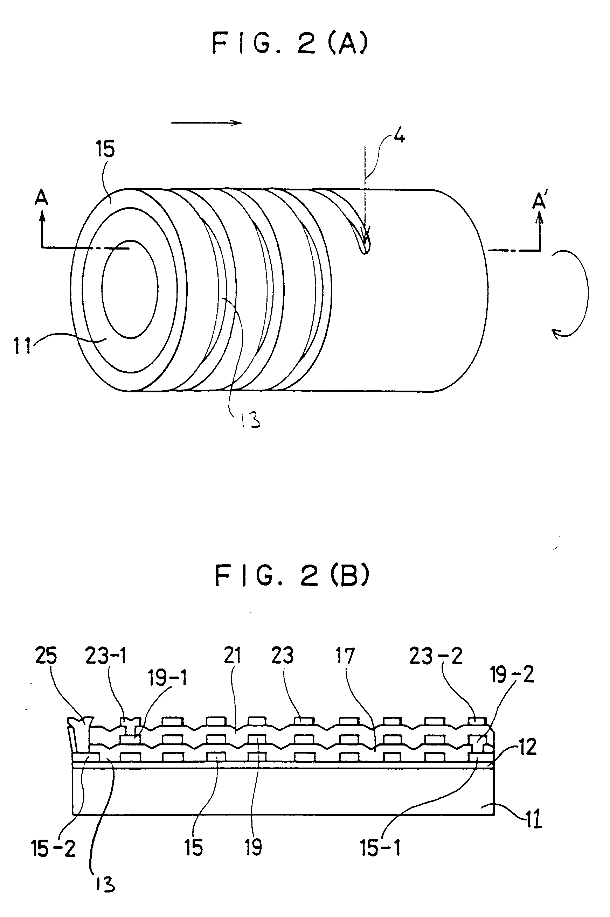

Referring now to Figs.2(A) and 2(B), another embodiment of the present invention will be described. In this embodiment, a procedure equivalent to that of the previous embodiment is carried out but on the surface of a cylinder 11. Deposition is performed on the cylindrical surface coated with a "non-superconducting ceramic" film 12 with the cylinder 11 being rotated as shown in Figure.2(A). The laser pulses 4 are directed along a path towards the right end of the rotating cylinder from its left end as indicated by the arrow in Figure.2(A). Accordingly, a helical groove 13 is cut into the superconducting film thereby forming a first superconducting helix 15. A first "non-superconducting ceramic" film 17 is formed with an opening at one end 15-1 of the first helix 15. A second superconducting helix 19 and a second "non-superconducting ceramic" film 21 with an opening at one end 19-1 of the second helix 19 are also formed in the same manner. The other end 19-2 of the second helix 19 is coupled with the first helix 15 through the opening of the first non-superconducting film 17. Another opening is formed penetrating through the first and second non-superconducting films 17 and 21. Furthermore, a third superconducting helix 23 is formed which is coupled at one end 23-1 thereof with the second superconducting helix 19 through the opening at its one end 19-1. Then, a triple-layered coil is formed. One terminal is the other end 23-2 of the third helix 23 and the other terminal is the other end 15-2 of the first helix 15. The other terminal is provided by a contact 25 which connects with the first helix 15 through the opening at the other end 15-2. thereof.

While the foregoing description is directed to methods of making superconducting ceramic patterns carried by substrates, light weighted superconducting coils which are not supported by substrates can also be formed. For this purpose, temporary substrates are prepared in the form of the substrates 1 and 11 as illustrated in Figs.1(A) and 1(B) and Figs.2(A) and 2(B). The temporary substrates have to be made of materials which are soluble by a suitable solvent, e.g. organic substances, but compatible with "non-superconducting ceramics". On the temporary substrate, a non-superconducting ceramic film 12 is formed to a thickness of 10-5000 microns, e.g. 20 microns for example. Thereafter, the procedures of the foregoing examples are repeated on the "non-superconducting ceramic" film 12 in order to make a multi-layered spiral coil and a multi-layered helical coil. After completing the formation of the coils, the temporary substrates are removed with a solvent.

If a further increased large number of turns is desired, a further number of superconducting ceramic layers, e.g. several tens of superconducting ceramic layers, with coils respectively formed thereon may be provided.

Although the helices are connected in series in Fig.2(B), the helices can be formed without interconnection therebetween, but the superconducting patterns on the ceramic layer can be designed to produce an individual pair of terminals for each helix so that the connection among the helices can be arbitrarily arranged.

Superconducting ceramics for use with the described embodiments may also be prepared in consistence with the stoichiometric formulae (A₁₋ₓBₓ)_{y}Cu_{z}O_{w}, where A is one or more elements of Group IIIa of the Periodic Table, e.g., the rare earth elements, B is one or more elements of Group IIa of the Periodic Table, e.g., the alkaline earth metals including Beryllium and Magnesium, and 0<x<1; y = 2.0 - 4.0, preferably 2.5-3.5; z = 1.0 - 4.0, preferably 1.5 - 3.5; and w = 4.0 - 10.0, preferably 6.0 - 8.0. also, superconducting ceramics for use with the described embodiments may be prepared consistent with the stoichiometric formulae (A₁₋ₓBₓ)_{y}Cu_{z}O_{w}, where A is one or more elements of Group Vb of the Periodic Table such as Bi, Sb and As, B is one or more elements of Group IIa of the Periodic Table, e.g., the alkaline earth metals including Beryllium and Magnesium, and x = 0.3 - 1; y = 2.0 - 4.0, preferably 2.5 - 3.5; z = 1.0 - 4.0, preferably 1.5 - 3.5; and w = 4.0 - 10.0, preferably 6.0 - 8.0. Examples of this general formula are BiSrCaCuCu₂Oₓ and Bi₄Sr₃Ca₃Cu₄Oₓ. Tc onset and Tco samples confirmed consistent with the formula Bi₄Sr_{y}Ca₃Cu₄Oₓ (y is around 1.5) were measured to be 40-60°K, which is not so high. Relatively high critical temperatures were obtained with samples conforming to the stoichiometric formulae Bi₄Sr₄Ca₂Cu₄Oₓ and Bi₂Sr₃Ca₂Cu₂Oₓ. The number designating the oxygen proportion is 6-10 e.g. around 8.1.

Hereinbefore, the description has been made of the embodiments in which superconducting spirals or helices are formed by eliminating unnecessary intervening portions between adjacent turns of the spirals or helices. However, superconducting patterns can also be produced by introducing one or more elements selected from a group consisting of Mg, Be, Al, Fe, Co, Ni, Cr, Ti, Mn and Zr into unnecessary portions of superconducting thin films by ion implantation in order to modify these portions to be non-superconducting, so that a superconducting pattern composed of a non-implanted portion remain superconductive. By use of such a method, smooth layered structures can be formed.

While a description has been made for several embodiments, the present invention should be limited only by the appended claims and should not be limited by the particular examples. For example, each spiral or helix may be formed with a metallic spiral or helix by, before or after forming a superconducting film, forming an underlying or overlying metallic film which is to be processed by laser scribing together with the superconducting film.

For the avoidance of doubt it is to be noted that all references herein and in the appended claims to the Periodic Table and to specific Groups of the Periodic Tables are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and O are the same as in the Japanese and European Periodic Tables, Groups IIIa, IVa, Va, VIa and VIIa of the Japanese Periodic Table correspond respectively to Groups IIIB, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

## Claims

1. A multilayered superconductive circuit comprising:
a lower superconductive coil (5,15) made of a superconductive ceramic material;
an intervening insulating ceramic layer (6,17) formed on said lower superconductive coil (5,15); and
an upper superconductive coil (7,19) made of a superconductive ceramic material insulated from said lower superconductive coil (5,15) by said insulating ceramic layer (6,17).

2. A circuit according to claim 1, wherein said lower and upper superconductive coils (5,15,7,19) are interconnected through an opening formed in said insulating ceramic layer (6,17).

3. A circuit according to claim 1 or 2, wherein said lower and upper coils (5,15,7,19) are arranged in opposite senses and are coupled in order to form a multilayered coil.

4. A circuit according to any preceding claim, wherein said lower coil (5,15) is formed on an insulating ceramic substrate (1).

5. A circuit according to any preceding claim, wherein said coils (5,15,7,19) are formed on a disk (1).

6. A circuit according to any of claims 1 to 4, wherein said coils (5,15,7,19) are formed on a cylindrical surface (11).

7. A circuit according to any preceding claim, wherein said insulating ceramic layer (6,17) is made of an oxide ceramic material conforming to the stoichiometric formula [(A′ₚA˝₁₋ₚ)₁₋ₓ(B′_{q}B˝_{1-q})ₓ]_{y}(CuᵣX₁₋ᵣ)_{z}O_{w}, where A′ is one or more elements of Group IIIa of the Periodic Table, e.g., the rare earth elements or lanthanides, B′ is one or more alkaline earth metals, i.e. Ba, Sr and Ca, A˝, B˝ and X are selected from a group consisting of Mg, Be, Al, Fe, Co, Ni, Cr, Ti, Mn and Zr, and 0<x<1; y = 2.0 - 4.0; z = 1.0 - 4.0; and w = 4.0 - 10.0, and the numbers p, q and r are chosen so that the total proportion of A˝, B˝ and X is 1-20 vol%, and
wherein said superconductive ceramic coils (5,15, 7,19) is made of materials conforming to the stoichiometric formula, (A₁₋ₓBₓ)_{y}Cu_{z}O_{w}, where A is one or more elements of Group IIIa of the Periodic Table, e.g., the rare earth elements or lanthanides, B is one or more alkaline earth metals, i.e. Ba, Sr and Ca, and 0<x<1; y = 2.0 - 4.0; z = 1.0 - 4.0; and w = 4.0 - 10.0.

8. A method of manufacturing a multilayered superconductive circuit comprising:
forming a first superconductive coil (5,15) made of a superconductive ceramic material;
insulating said first coil (5,15) by covering the coil (5,15) with an insulating layer (6,17) made of a ceramic material; and
forming a second superconductive coil (7,19) made of a superconductive ceramic material.

9. A method according to claim 8, wherein the ceramic material of said insulating layer (6,17) is selected from materials having a thermal expansion coefficient approximately equal to that of said superconductive coils (5,15, 7,19).

10. A method according to claim 8 or 9, wherein said second superconductive coil (7,19) is formed in the opposite sense to that of said first superconductive coil (5,15).

11. A method according to any of claims 8 to 10, wherein said first and second superconductive coils (5,15,7,19) are interconnected to form a double-layered coil.

12. A method according to any of claims 8 to 11, wherein said first superconductive coil (5,15) is formed on a ceramic surface (1).

13. A method according to any of claims 8 to 12, wherein said first superconductive coil is formed on a disk (1).

14. A method according to any of claims 8 to 12, wherein said first superconductive coil (5,15) is formed on a cylinder (11).

15. A method according to any of claims 12 to 14, wherein said ceramic surface, disk (1) or cylinder (11) is comprised of a material having a thermal expansion coefficient within 50% of that of said first superconductive coil (5,15).

16. A method according to any of claims 8 to 15, further comprising:
providing a temporary substrate (1,11) of a material which is soluble to a suitable solvent;
covering the surface (1′) of said substrate (1,11) with an insulating ceramic layer (12);
forming said first superconductive ceramic coil (5,15) on the surface of said insulating ceramic layer (12); and
removing said temporary substrate (1,11) with said solvent.

17. A method according to any of claims 8 to 16, further comprising:
forming a further insulating layer (21) made of a ceramic material; and
forming a further superconductive coil (23) made of a superconductive material on said further insulating layer (21).

18. A method according to claim 17, wherein said steps of forming said further insulating layer (21) and said further superconductive coil (23) are repeated one or more times in order to form a multi-layered coil having four or more layers.

19. A method according to any of claims 8 to 18, wherein at least one of said first and second superconductive coils (5,15,7,19) is formed by:
forming a layer comprising said superconductive ceramic material; and
removing unnecessary portions (3,13) of said superconductive ceramic material by irradiating said portions (3,13) with a laser.

20. A method according to any of claims 8 to 18, wherein at least one of said first and second superconductive coils (5,15,7,19) is formed by:
forming a layer comprising said superconductive ceramic material; and
introducing an impurity element into unnecessary portions (3,13) of said superconductive layer in order to hinder superconductivity in said portions (3,13).

## Patentansprüche

1. Mehrschichtige supraleitende Schaltung umfassend:
eine untere supraleitende Spule (5, 15) aus einem supraleitenden keramischen Werkstoff;
eine dazwischenliegende keramische Isolierschicht (6, 17), die auf die untere supraleitende Spule (5, 15) aufgebracht ist; und
eine obere supraleitende Spule (7, 19) aus einem supraleitenden keramischen Werkstoff, die durch die keramische Isolierschicht (6, 17) von der unteren supraleitenden Spule (5, 15) isoliert ist.

2. Schaltung nach Anspruch 1, bei der die untere und die obere supraleitende Spule (5, 15, 7, 19) durch eine in der keramischen Isolierschicht vorgesehene Öffnung miteinander verbunden sind.

3. Schaltung nach Anspruch 1 oder 2, bei der die untere und die obere Spule (5, 15, 7, 19) entgegengesetzt angeordnet und derart miteinander verbunden sind, daß sie eine mehrschichtige Spule bilden.

4. Schaltung nach einem der vorhergehenden Ansprüche, bei der die untere Spule (5, 15) auf einem isolierenden keramischen Substrat (1) vorgesehen ist.

5. Schaltung nach einem der vorhergehenden Ansprüche, bei der die Spulen (5, 15, 7, 19) auf einer Scheibe (1) vorgesehen sind.

6. Schaltung nach einem der Ansprüche 1 bis 4, bei der die Spulen (5, 15, 7, 19) auf einer zylindrischen Fläche (1) vorgesehen sind.

7. Schaltung nach einem der vorhergehenden Ansprüche,
bei der die keramische Isolierschicht (6, 17) aus einem keramischen Oxyd besteht, das der stöchiometrischen Formel [(A′ₚA˝₁₋ₚ)₁₋ₓ (B′_{q}B˝_{1-q})ₓ]_{y}(CuᵣX₁₋ᵣ)_{z}O_{w} entspricht, wobei A′ ein Element bzw. mehrere Elemente der Gruppe IIIa des Periodensystems, z.B. die Metalle der Seltenerden oder die Elemente der Lanthanreihe, darstellt, B′ ein bzw. mehrere Erdalkalimetalle, d.h. Ba, Sr und Ca, darstellt, A˝, B˝ und X aus der Gruppe Mg, Be, Al, Fe, Co, Ni, Cr, Ti, Mn und Zr ausgewählt sind, und 0<x<1; y = 2.0 bis 4.0; z = 1.0 bis 4.0; und W = 4.0 bis 10.0 und die Parameter p, 1 und r derart ausgewählt sind, daß das Gesamtverhältnis von A˝, B˝ und X zwischen 1-20 Vol% liegt, und
bei der die supraleitenden keramischen Spulen (5, 15, 7, 19) aus Werkstoffen bestehen, die der stöchiometrischen Formel (A₁₋ₓBₓ)Cu_{z}O_{w} entsprechen, wobei A ein Element bzw. mehrere Elemente der Gruppe IIIa des Periodensystems, z.B. die Metalle der Seltenerden oder die Elemente der Lanthanreihe, darstellt, B ein bzw. mehrere Erdalkalimetalle, d.h. Ba, Sr und Ca, darstellt, und 0<x<1; y = 2.0 bis 4.0; z = 1.0 bis 4.0; und W = 4.0 bis 10.0.

8. Verfahren zur Herstellung einer mehrschichtigen supraleitenden Schaltung, bei dem
eine erste supraleitende Spule (5, 15) aus einem supraleitenden keramischen Werkstoff gebildet wird;
diese erste Spule (5, 15) dadurch isoliert wird, daß sie mit einer Isolierschicht (6, 17) aus einem keramischen Werkstoff bedeckt wird; und
eine zweite supraleitende Spule (7, 19) aus einem supraleitenden keramischen Werkstoff gebildet wird.

9. Verfahren nach Anspruch 8, bei dem der keramische Werkstoff der Isolierschicht (6, 17) aus Werkstoffen ausgewählt wird, die einen Wärmeausdehnungskoeffizienten aufweist, der dem der supraleitenden Spulen (5, 15, 7, 19) etwa gleicht.

10. Verfahren nach Anspruch 8 oder 9, bei dem die zweite supraleitende Spule (7, 19) im entgegengesetzten Sinne zu der ersten supraleitenden Spule (5, 15) vorgesehen wird.

11. Verfahren nach einem der Ansprüche 8 bis 10, bei dem die erste und zweite supraleitende Spule (5, 15, 7, 19) derart miteinander verbunden sind, daß sie eine zweischichtige Spule bilden.

12. Verfahren nach einem der Ansprüche 8 bis 11, bei dem die erste supraleitende Spule (5, 15) auf einer keramischen Fläche (1) vorgesehen wird.

13. Verfahren nach einem der Ansprüche 8 bis 12, bei dem die erste supraleitende Spule auf einer Scheibe (1) vorgesehen wird.

14. Verfahren nach einem der Ansprüche 8 bis 12, bei dem die erste supraleitende Spule (5, 15) auf einem Zylinder (11) vorgesehen wird.

15. Verfahren nach einem der Ansprüche 12 bis 14, bei dem die keramische Fläche, die Scheibe (1) bzw. der Zylinder (11) aus einem Werkstoff besteht, der einen Wärmeausdehnungskoeffizienten aufweist, der bis zu 50% des Wärmeausdehnungskoeffizienten der ersten supraleitenden Spule (5, 15) beträgt.

16. Verfahren nach einem der Ansprüche 8 bis 15, bei dem:
ein vorläufiges Substrat (1, 11) vorgesehen wird, das aus einem in einem geeigneten Lösungsmittel lösbaren Werkstoff besteht;
die Fläche (1′) des Substrats (1, 11) mit einer keramischen Isolierschicht (12) bedeckt wird;
die erste supraleitende keramische Spule (5, 15) auf die Fläche der keramischen Isolierschicht (12) aufgebracht wird; und
das vorläufige Substrat (1, 11) mit dem Lösungsmittel entfernt wird.

17. Verfahren nach einem der Ansprüche 8 bis 16, bei dem:
eine weitere Isolierschicht (21) aus einem keramischen Werkstoff gebildet wird; und
eine weitere supraleitende Spule (23) aus einem supraleitenden Werkstoff auf diese weitere Isolierschicht (21) aufgebracht wird.

18. Verfahren nach Anspruch 17, bei dem die Schritte der Bildung der weiteren Isolierschicht (21) und der weiteren supraleitenden Spule (23) einmal oder mehrmals wiederholt werden, um eine mehrschichtige Spule aus vier oder mehr Schichten zu bilden.

19. Verfahren nach einem der Ansprüche 8 bis 18, bei dem die erste und/oder die zweite supraleitende Spule (5, 15, 7, 19) dadurch gebildet wird, daß:
eine Schicht aus dem supraleitenden keramischen Werkstoff gebildet wird; und
die überflüssigen Teile (3, 13) des supraleitenden keramischen Werkstoffs dadurch entfernt werden, daß diese Teile (3, 13) mit einem Laser bestrahlt werden.

20. Verfahren nach einem der Ansprüche 8 bis 18, bei dem die erste und/oder die zweite supraleitende Spule (5, 15, 7, 19) dadurch gebildet wird, daß:
eine Schicht aus dem supraleitenden keramischen Werkstoff gebildet wird; und
ein Fremdbestandteil in die überflüssigen Teile (3, 13) der supraleitenden Schicht eingebracht werden, um die Supraleitfähigkeit in diesen Teilen (3, 13) zu hemmen.

## Revendications

1. Circuit supraconducteur multicouche comprenant :
une bobine supraconductrice inférieure (5, 15) constituée d'un matériau céramique supraconducteur ;
une couche céramique isolante intermédiaire (6, 17) formée sur ladite bobine supraconductrice inférieure (5, 15) ; et
une bobine supraconductrice supérieure (7, 19) constituée d'un matériau céramique supraconducteur isolé de ladite bobine supraconductrice inférieure (5, 15) par ladite couche céramique isolante (6, 17).

2. Circuit selon la revendication 1, dans lequel lesdites bobines supraconductrices inférieure et supérieure (5, 15, 7, 19) sont interconnectées à travers une ouverture formée dans ladite couche céramique isolante (6, 17).

3. Circuit selon la revendication 1 ou 2, dans lequel lesdites bobines inférieure et supérieure (5, 15, 7, 19) sont disposées dans des sens opposés et couplées pour former une bobine multicouche.

4. Circuit selon l'une quelconque des revendications précédentes, dans lequel ladite bobine inférieure (5, 15) est formée sur un substrat céramique isolant (1).

5. Circuit selon l'une quelconque des revendications précédentes, dans lequel lesdites bobines (5, 15, 7, 19) sont formées sur un disque (1).

6. Circuit selon l'une quelconque des revendications 1 à 4, dans lequel lesdites bobines (5, 15, 7, 19) sont formées sur une surface cylindrique (11).

7. Circuit selon l'une quelconque des revendications précédentes, dans lequel ladite couche céramique isolante (6, 17) est constituée d'un matériau céramique oxydé répondant à la formule brute [(A′ₚA˝₁₋ₚ)₁₋ₓ(B′_{q}B˝_{1-q})ₓ]_{y}(CuᵣX₁₋ᵣ)_{z}O_{w}, dans laquelle A′ représente un ou plusieurs éléments du Groupe IIIa de la Classification Périodique, par exemple les éléments de terres rares ou les lanthanides, B′ représente un ou plusieurs métaux alcalino-terreux, à savoir Ba, Sr et Ca, A˝, B˝ et X sont choisis dans le groupe constitué par Mg, Be, Al, Fe, Co, Ni, Cr, Ti, Mn et Zr, et 0<x<1 ; y = 2,0 - 4,0 ; z = 1,0 - 4,0 ; et w = 4,0 - 10,0 ; et les nombres p, q et r sont choisis de telle sorte que la proportion totale de A˝, B˝ et X soit de 1 à 20 % en volume, et
dans lequel lesdites bobines céramiques supraconductrices (5, 15, 7, 19) sont constituées de matériaux répondant à la formule brute (A₁₋ₓBₓ)_{y}Cu_{z}O_{w}, dans laquelle A représente un ou plusieurs éléments du Groupe IIIa de la classification périodique, par exemple les éléments de terres rares ou les lanthanides, B représente un ou plusieurs métaux alcalino-terreux, à savoir Ba, Sr et Ca, et 0<x<1 ; y = 2,0 - 4,0 ; z = 1,0 - 4,0 ; et w = 4,0 - 10,0.

8. Procédé de fabrication d'un circuit supraconducteur multicouche, comprenant les étapes consistant :
à former une première bobine supraconductrice (5, 15) constituée d'un matériau céramique supraconducteur ;
à isoler ladite première bobine (5, 15) en la recouvrant d'une couche isolante (6, 17) constituée d'un matériau céramique ; et
à former une seconde bobine supraconductrice (7, 19) constituée d'un matériau céramique supraconducteur.

9. Procédé selon la revendication 8, dans lequel le matériau céramique de ladite couche isolante (6, 17) est choisi parmi les matériaux ayant un coefficient de dilatation thermique approximativement égal à celui desdites bobines supraconductrices (5, 15, 7, 19).

10. Procédé selon la revendication 8 ou 9, dans lequel ladite seconde bobine supraconductrice (7, 19) est formée dans le sens opposé à celui de ladite première bobine supraconductrice (5, 15).

11. Procédé selon l'une quelconque des revendications 8 à 10, dans lequel lesdites première et seconde bobines supraconductrices (5, 15, 7, 19) sont interconnectées pour former une bobine à double couche.

12. Procédé selon l'une quelconque des revendications 8 à 11, dans lequel ladite première bobine supraconductrice (5, 15) est formée sur une surface céramique (1).

13. Procédé selon l'une quelconque des revendications 8 à 12, dans lequel ladite première bobine supraconductrice est formée sur un disque (1).

14. Procédé selon l'une quelconque des revendications 8 à 12, dans lequel ladite première bobine supraconductrice (5, 15) est formée sur un cylindre (11).

15. Procédé selon l'une quelconque des revendications 12 à 14, dans lequel ladite surface céramique, ledit disque (1) ou ledit cylindre (11), est constitué(e) d'un matériau ayant un coefficient de dilatation thermique dans la limite de 50 % de celui de ladite première bobine supraconductrice (5, 15).

16. Procédé selon l'une quelconque des revendications 8 à 15, comprenant en outre les étapes consistant :
à se procurer un substrat temporaire (1, 11) d'un matériau qui est soluble dans un solvant approprié ;
à recouvrir la surface (1′) dudit substrat (1, 11) d'une couche céramique isolante (12) ;
à former ladite première bobine céramique supraconductrice (5, 15) sur la surface de ladite couche céramique isolante (12) ; et
à éliminer ledit substrat temporaire (1, 11) avec ledit solvant.

17. Procédé selon l'une quelconque des revendications 8 à 16, comprenant en outre les étapes consistant :
à former une autre couche isolante (21) constituée d'un matériau céramique ; et
à former une autre bobine supraconductrice (23) constituée d'un matériau supraconducteur sur ladite autre couche isolante (21).

18. Procédé selon la revendication 17, dans lequel lesdites étapes de formation de ladite autre couche isolante (21) et de ladite autre bobine supraconductrice (23) sont répétées une ou plusieurs fois pour former une bobine multicouche ayant quatre couches ou davantage.

19. Procédé selon l'une quelconque des revendications 8 à 18, dans lequel on réalise au moins l'une desdites première et seconde bobines supraconductrices (5, 15, 7, 19) :
en formant une couche comprenant ledit matériau céramique supraconducteur ; et
en éliminant les parties non nécessaires (3, 13) dudit matériau céramique supraconducteur par irradiation desdites parties (3, 13) avec un laser.

20. Procédé selon l'une quelconque des revendications 8 à 18, dans lequel on réalise au moins l'une desdites première et seconde bobines supraconductrices (5, 15, 7, 19) :
en formant une couche comprenant ledit matériau céramique supraconducteur ; et
en introduisant un élément d'impureté dans les parties non nécessaires (3, 13) de ladite couche supraconductrice pour empêcher une supraconductibilité dans lesdites parties (3, 13).
